# EUROPÄISCHE PATENTSCHRIFT

(11) **EP 4 537 053 B1**
(45) Veröffentlichungstag und Bekanntmachung des Hinweises auf die Patenterteilung: **25.11.2026**
(21) Anmeldenummer: 23728274.4
(22) Anmeldetag: 16.05.2023
(51) Int. Cl.: G01C 19/5684

(54) **RINGFÖRMIGER MIKROELEKTROMECHANISCHER DREHRATENSENSOR**
ANNULAR MICROELECTROMECHANICAL ANGULAR RATE SENSOR
CAPTEUR DE VITESSE ANGULAIRE MICROÉLECTROMÉCANIQUE ANNULAIRE

(30) Priorität: 08.06.2022 DE 102022114407
(43) Veröffentlichungstag der Anmeldung: 16.04.2025
(60) Teilanmeldung: 26167127.5 / 4 741 763; 26167135.8 / 4 741 764; 26167215.8 / 4 741 765
(73) Patentinhaber: Northrop Grumman LITEF GmbH, 79115 Freiburg (DE)
(72) Erfinder: RENDE, Jan Daniel, 66629 Freisen (DE)
(74) Vertreter: Müller Hoffmann & Partner
(86) Internationale Anmeldenummer: PCT/EP2023/063098
(87) Internationale Veröffentlichungsnummer: WO 2023/237303

(56) Entgegenhaltungen:
- WO-A1-2022/007101

## Beschreibung

Die vorliegende Erfindung betrifft ringförmige mikroelektromechanische Drehratensensoren.

Ringförmige mikroelektromechanische Drehratensensoren arbeiten nach dem Prinzip, dass eine in sich geschlossene Struktur, die typischerweise als Kreis bzw. Ring ausgestaltet ist, über einem Substrat in Schwingung parallel zur Substratebene gebracht wird. Wird der Ring um eine senkrecht zur Substratebene stehende Drehachse gedreht, erzeugt die Schwingungsbewegung des Rings eine Corioliskraft auf die einzelnen Massenpunkte des Rings. Dies führt zur Überlagerung einer weiteren Schwingung, deren Amplitude von der Drehrate der Drehung abhängt. Da die Schwingungsrichtung dieser Detektionsschwingung durch die Lage des Rings und die Anregungsschwingung im Prinzip vorgegeben ist und auch die Parameter der Anregungsschwingung bekannt sind, kann die Detektionsschwingung ausgelesen werden, um so die Drehrate zu bestimmen.

Derartige Drehratensensoren sind z.B. aus der WO 2022/007101 A1 bekannt.

In der Praxis werden zum Anregen und Auslesen der Schwingungen häufig entlang des Ringumfangs platzierte Plattenelektroden verwendet. Dies ist aber platzraubend und wird nicht sämtlichen Anforderungen an den Drehratensensor gerecht. Derartige Plattenelektroden können auch genutzt werden, um sogenannte Quadraturfehler zu kompensieren, mit denen mikroelektromechanische Sensoren aufgrund von unvermeidlich auftretenden Fertigungstoleranzen oft behaftet sind.

Hierbei tritt aber das Problem auf, dass außen entlang des Ringumfangs platzierte Elektrodenplatten bezüglich der Elektrodenfläche limitiert sind. Da über eine größere Elektrodenfläche ein größeres Signal eingespeist bzw. ausgelesen werde kann, ist die Verwendung von außenliegenden Elektrodenplatten nachteilig. Auch ist es bei außenliegenden Elektrodenplatten nicht immer möglich, Anregungs- und Ausleseelektroden optimal auszulegen

Aufgabe der vorliegenden Erfindung ist damit, ringförmige mikroelektromechanische Drehratensensoren mit großer Elektrodenfläche anzugeben, die kompakt aufgebaut sind und die eine Kompensation von Quadraturfehlern erlauben, ohne die Möglichkeit einzuschränken, den Ring des Drehratensensors anzuregen bzw. Schwingungen auszulesen.

Diese Aufgabe wird durch den Gegenstand der Ansprüche gelöst.

Ein mikroelektromechanischer Drehratensensor weist eine flexible Ringstruktur auf, die in Ruhe einen Kreis formt und geeignet ist, im Wesentlichen parallel zu der Ebene des Kreises über einem Substrat eine Anregungsschwingung auszuführen, der bei einer Drehung der Ringstruktur eine durch die Corioliskraft erzeugte Detektionsschwingung überlagert wird. Der Drehratensensor weist zudem zumindest eine Kopplungsstruktur auf, die mit der Ringstruktur verbunden und derart ausgebildet ist, dass sie geeignet ist, zusammen mit auf dem Substrat feststehenden Elektroden einen Quadraturfehler des Drehratensensors zu kompensieren.

Es wird also nicht mehr versucht, Quadraturfehler über Plattenelektroden oder dergleichen auszugleichen, die direkt auf die Ringstruktur des Drehratensensors einwirken. Stattdessen wird eine Kopplungsstruktur mit der Ringstruktur verbunden, die mit Kompensationskräften beaufschlagt werden kann. Die Kopplungsstruktur gibt diese Kompensationskräfte dann an die Ringstruktur weiter und kann dadurch Quadraturfehler kompensieren. Die konkrete Ausgestaltung der Kopplungsstruktur ist dabei beliebig, solange die von den Kompensationskräften hervorgerufenen Bewegungen der Kopplungsstruktur auf die Ringstruktur in ausreichendem Maß übertragen werden, um über die Stärke der Kompensationskräfte eine kontrollierbare und messbare Beeinflussung der Bewegungen der Ringstruktur herbeiführen zu können. Aufgrund der in mikroelektromechanischen Vorrichtungen üblicher Weise auftretenden kleinen Schwingungsamplituden, ist es hierbei typischer Weise ausreichend, wenn eine Kompensation in erster Näherung stattfindet.

Zudem erlaubt die Verwendung der Kopplungsstruktur, eine freiere Platzierung und Ausgestaltung von Elektroden, womit eine insgesamt größere Elektrodenfläche bereitgestellt und eine vorteilhafte Auslegung von Elektroden mit verschiedener Funktion ermöglicht werden kann, wie etwa von Anregungs- und Ausleseelektroden.

Insbesondere ermöglicht es die Verwendung der Kopplungsstruktur, insbesondere bei entsprechender Auslegung der Federsteifigkeiten der verschiedenen Komponenten des Drehratensensors, zu erreichen, dass die Größe der Amplitude der von der Ringstruktur ausgeführten Schwingungen größer ist als die Größe der Schwingungsamplituden der Kopplungsstruktur. Auch dies kann für eine vorteilhafte Auslegung der Elektroden genutzt werden, z.B. um kleinere Spaltabstände oder einen Betrieb im linearen Bereich zu erreichen.

Der Drehratensensor weist des Weiteren erste Federelemente auf, die die Ringstruktur mit dem Substrat verbinden, wobei die zumindest eine Kopplungsstruktur und die ersten Federelemente an der gleichen Seite der Ringstruktur angreifen. Die Ringstruktur ist also über Federelemente mit dem Substrat verbunden. Auf diese Weise wird sichergestellt, dass die Ringstruktur möglichst frei schwingen kann. Sämtliche Federelemente greifen dabei auf einer Seite der Ringstruktur an, d.h. entweder von innen oder von außen, um eine gegenüber dem Substrat kräfte- und momentenfreie Kopplung zu gewährleisten. Die eine oder mehrere Kopplungsstrukturen greifen dann auf der gleichen Seite wie die Federelemente an. Auf diese Weise lässt sich ein relativ kompakter Aufbau des Drehratensensors erreichen, da wichtige Komponenten des Drehratensensors zusammen angeordnet sind. Insbesondere bei einer Anordnung der Komponenten im Inneren der Ringstruktur wird die Größe des Drehratensensors von der Größe der Ringstruktur bestimmt.

Der Drehratensensor kann eine Mehrzahl der Kopplungsstrukturen aufweisen, die gleichmäßig entlang der Umfangsrichtung der Ringstruktur verteilt sind. Dadurch wird das Ansprechverhalten und die Möglichkeit Quadraturfehler zu kompensieren verbessert. Zudem können die Kopplungsstrukturen aufgrund der gleichmäßigen Verteilung baugleich ausgebildet werden, ohne ungleichmäßige Kräfteverteilungen auf die Ringstruktur herbeizuführen. Dies vereinfacht die Herstellung des Drehratensensors.

Die Elektroden zur Kompensation der Quadraturfehler können in elektrischer Wechselwirkung mit Teilen der Kopplungsstrukturen stehen, die sich im Wesentlichen in radialer Richtung der Ringstruktur erstrecken. Dadurch wird ermöglicht, die Kopplungsstrukturen in effektiver Weise in Umfangsrichtung der Ringstruktur zu drehen, d.h. um eine senkrecht auf der Substratebene stehende Achse. Diese Drehung wird aufgrund der entsprechenden Ausgestaltung der Kopplungsstrukturen auf die Ringstruktur übertragen und führt dort zu die Quadraturfehler kompensierenden Kräften.

Die Kopplungsstrukturen können als Rahmen ausgebildet sein, die an einer ersten Seite mit der Ringstruktur und an einer zweiten gegenüberliegenden Seite mit dem Substrat verbunden sind. Zumindest ein Teil der auf dem Substrat feststehenden Elektroden ist dann innerhalb der Rahmen ausgebildet. Hierdurch wird ein kompakter Aufbau erreicht, da die zur Steuerung des Drehratensensors verwendeten Elektroden ganz oder teilweise innerhalb der Kopplungsstrukturen angeordnet werden können, sodass kein weiterer Platzbedarf entsteht.

Die Elektroden zur Kompensation von Quadraturfehlern können in elektrischer Wechselwirkung mit dritten Seiten der Rahmen stehen, die sich im Wesentlichen in radialer Richtung der Ringstruktur erstrecken. Die oben beschriebene Wechselwirkung zur Kompensation von Quadraturfehlern erfolgt also über entsprechen ausgerichtete Seiten des Rahmens.

Die ersten und zweiten Seiten der Rahmen können länger sein als die dritten Seiten der Rahmen. In radialer Richtung sind die Rahmen damit relativ kurz, während sie in tangentialer Richtung relativ lang sind. Der Verbindungspunkt zwischen Rahmen und Ringstruktur, der an der entsprechenden ersten Seite liegt, hat also in Bezug auf die Abmessungen des Rahmens einen relativ großen Abstand zur Stelle an der die Elektroden zur Kompensation von Quadraturfehlern angeordnet sind. Es existiert also ein langer Hebelarm zwischen dem Ort, an dem die Kraft zur Kompensation von Quadraturfehlern erzeugt wird und dem Ort, an dem sie auf die Ringstruktur übertragen wird. Dadurch reichen relative kleine Anregungen mittels der Elektroden zur Kompensation von Quadraturfehlern aus, um diese Kompensation herbeizuführen. Dadurch wird die Kompensation vereinfacht, da auf Ladungen oder Spannungen an den Elektroden verzichtet werden kann, deren Größe zu anderen Problemen, wie etwa Übersprechen oder dergleichen führen kann. Zudem wird der Energieverbrauch reduziert.

Die Kopplungsstrukturen können derart ausgebildet sein, dass sie geeignet sind, zusammen mit auf dem Substrat feststehenden Elektroden die Anregungsschwingung zu erzeugen und/oder die Detektionsschwingung zu messen. Das heißt, nicht nur die Kompensation der Quadraturfehler sondern auch Anregen und Auslesen der Schwingungen der Ringstruktur können über die Kopplungsstrukturen vermittelt werden. Damit ist ein verbesserter Betrieb von Drehratensensoren möglich. Antrieb, Auslesen und/oder Fehlerkompensationen können hierbei von den gleichen oder auch von jeweils verschiedenen Kopplungsstrukturen vermittelt werden. Die oben genannten Vorteile hinsichtlich der Elektrodenfläche und/oder der Elektrodenauslegung kommen hierbei dann sämtlichen Elektroden zugute.

Der Drehratensensor kann des Weiteren zweite Federelemente aufweisen, die die Kopplungsstrukturen mit der Ringstruktur verbinden, wobei die zweiten Federelemente in radialer

Richtung der Ringstruktur derart verformbar sind, dass eine radiale Auslenkung der Kopplungsstrukturen zu einer größeren radialen Auslenkung der Ringstruktur führt. Die zwischen Kopplungsstrukturen und Ringstruktur angebrachten zweiten Federelemente dienen also der Amplitudenverstärkung. Vergleichsweise kleine Auslenkungen der Kopplungsstrukturen mit kurzer und großer Beschleunigung (vergleichbar einem Kraftstoß) werden von den zweiten Federelementen aufgenommen. Die zweiten Federelemente sind derart ausgestaltet, dass dieser Kraftstoß mit geringer Amplitude zu einer Verformung in radialer Richtung führt, die an der Ringstruktur eine größere (und langsamere) Auslenkung hervorruft, als dies für die Kopplungsstruktur der Fall war. Dies hat den Vorteil, dass der Ringstruktur große Amplituden aufgeprägt werden können, ohne dass Platz für ähnlich große Amplituden an den Kopplungsstrukturen vorgehalten werden muss. Dadurch kann der Platzbedarf weiter reduziert werden. Zudem erlaubt eine derartige Amplitudenverstärkung, die Kopplungsstrukturen mit relativ geringen Auslenkungen anzuregen bzw. auszulesen. Damit können die entsprechenden Elektroden mit geringer Spaltbreite ausgelegt werden und im linearen Bereich betrieben werden. Gleichzeitig bleiben die Schwingungsamplituden der Ringstruktur groß, was für eine präzise Drehratenbestimmung vorteilhaft ist.

Der Drehratensensor kann dritte Federelemente aufweisen, die die Kopplungsstrukturen mit dem Substrat verbinden. Dadurch kann die Beweglichkeit der Kopplungsstrukturen verbessert werden. Dies macht die Kräfteübertragung zwischen Kopplungsstrukturen und Ringstruktur flexibler, da auch die Kopplungsstrukturen als Ganzes bewegt werden können und Bewegungen nicht nur aus der Verformung der Kopplungsstrukturen resultieren müssen.

Zumindest zwei der Kopplungsstrukturen können derart miteinander gekoppelt sein, dass ihre Bewegungen miteinander gekoppelt sind. Insbesondere können die Kopplungsstrukturen durch die Kopplung zu Bewegungen im Gleichtakt oder im Gegentakt gezwungen werden. Dies kann die Stabilität der Schwingungen im Drehratensensor und damit die Auslesegenauigkeit verbessern.

Die vorliegende Erfindung wird im Folgenden mit Bezug auf die Figuren beispielhaft beschrieben. Die folgende Beschreibung darf nicht als einschränkend verstanden werden. Die vorliegende Erfindung ist allein durch den Gegenstand der Ansprüche definiert. Es zeigt:
- **Fig. 1**: eine schematische Darstellung eines ringförmigen mikromechanischen Drehratensensors;
- **Fig. 2**: eine weitere schematische Darstellung eines ringförmigen mikromechanischen Drehratensensors;
- **Fig. 3**: eine weitere schematische Darstellung eines ringförmigen mikromechanischen Drehratensensors;
- **Fig. 4**: eine schematische Darstellung von Elektroden zur Kompensation von Quadraturfehlern eines ringförmigen Drehratensensors;
- **Fig. 5**: eine schematische Darstellung von plattenförmigen Elektroden zum Anregen und/oder Auslesen von Schwingungen eines ringförmigen Drehratensensors;
- **Fig. 6**: eine schematische Darstellung von kammförmigen Elektroden zum Anregen und/oder Auslesen von Schwingungen eines ringförmigen Drehratensensors; und
- **Fig. 7**: eine schematische Darstellung von verschiedenen Elektroden zum Betreiben eines ringförmigen Drehratensensors.

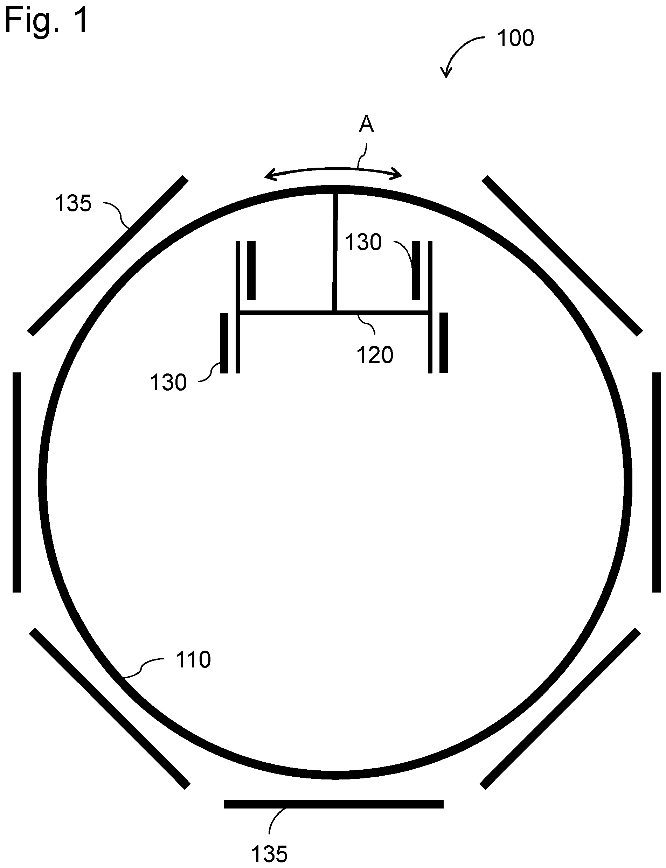

Die Fig. 1 zeigt eine schematische Darstellung eines ringförmigen mikroelektromechanischen Drehratensensors 100. Der Drehratensensor weist eine flexible Ringstruktur 110 auf, die in Ruhe einen Kreis formt und geeignet ist, im Wesentlichen parallel zu der Ebene des Kreises über einem Substrat eine Anregungsschwingung auszuführen, der bei einer Drehung der Ringstruktur 110 eine durch die Corioliskraft erzeugte Detektionsschwingung überlagert wird.

Die Ringstruktur 110 kann hierbei z.B. eine in sich geschlossene Biegebalkenfeder sein, die über dem parallel zur Bildebene liegenden Substrat (nicht gezeigt) angeordnet ist. Das heißt, die Ringstruktur 110 besteht im Wesentlichen aus einem Steg, dessen Höhe (senkrecht zur Bildebene) wesentlich höher ist als seine Breite (in Bildebene). Dadurch kann die Ringstruktur parallel zum Substrat verformt werden, während sie gegenüber Verformungen senkrecht zum Substrat steif und unflexibel ist.

Um Drehraten zu messen wird die Ringstruktur 110 in eine Grundschwingung bzw. Anregungsschwingung versetzt, die z.B. zu einer elliptischen Deformation entlang einer bestimmten Richtung führt. Dreht sich der Drehratensensor 100 um eine Achse, die senkrecht zum Substrat steht, wird aufgrund der durch die Anregungsschwingung auftretenden Bewegungen eine Corioliskraft auf die Massenpunkte der Ringstruktur 110 erzeugt, die zu einer Änderung der Schwingung der Ringstruktur 110 führt. Diese Änderung kann z.B. als die Überlagerung einer weiteren Schwingung über die Anregungsschwingung betrachtet werden, wobei sich die Schwingungsrichtung dieser Detektionsschwingung von der Schwingungsrichtung der Anregungsschwingung unterscheidet. Anders ausgedrückt werden durch die Corioliskraft Schwingungsmoden angeregt, die sich von der/den Schwingungsmode(n) der Anregungsschwingung unterscheiden. Diese Änderung der von der Ringstruktur 110 ausgeführten Schwingung lässt sich messen, um hieraus die Drehrate der Drehung zu bestimmen.

Obwohl die Ringstruktur 110 in Ruhe als Kreis dargestellt ist, soll dies keine Formen ausschließen, die in der gleichen Weise für die Detektion von Corioliskräften/Drehraten geeignet sind. So kann die Ringstruktur 110 auch in Ruhe von der Kreisform abweichen und z.B. als deformierter Kreis, als ein Vieleck mit oder ohne abgerundeten Kanten oder dergleichen ausgebildet sein. All diese Abwandlungen sollen als unter den Begriff "Kreis" fallend verstanden werden.

Der Drehratensensor 100 weist zudem zumindest eine Kopplungsstruktur 120 auf, die mit der Ringstruktur 110 verbunden und derart ausgebildet ist, dass sie geeignet ist, zusammen mit auf dem Substrat feststehenden Elektroden 130 einen Quadraturfehler des Drehratensensors 100 zu kompensieren. Derartige Quadraturfehler sind nahezu unweigerlich aufgrund von während der Herstellung von mikroelektromechanischen Komponenten auftretenden Fertigungstoleranzen vorhanden. Insbesondere durch die Verwendung von Ätzprozessen bei der Herstellung können an sich gleich ausgelegte Komponenten leicht unterschiedlich dimensioniert sein. Zum Beispiel kann die Dicke der Ringstruktur 110 entlang der Umfangsrichtung variieren. Dies führt zu unterschiedlichen Federhärten und damit zu einem nicht gewünschten, unterschiedlichen Antwortverhalten auf Krafteinwirkungen. Um den Drehratensensor 100 so betreiben zu können, als ob diese Abweichungen vom Idealverhalten nicht vorhanden wären, müssen die Abweichungen durch zusätzlichen Krafteintrag kompensiert werden.

Dies wird üblicherweise mit Plattenelektroden 135 versucht, die außen oder innen an der Ringstruktur 110 angeordnet sind und mit dieser elektrisch wechselwirken. Hier besteht aber das Problem, dass Kompensationskräfte aufgrund der flächigen Ausgestaltung der Plattenelektroden 135 nicht ausreichend zielgerichtet erzeugt werden können. Zudem ist es nicht möglich, über die Plattenelektroden 135 Kräfte mit beliebiger Richtung auf Ringstruktur 110 wirken zu lassen, und die Fläche, die für die Plattenelektroden 135 zur Verfügung steht ist durch den Umfang der Ringstruktur 110 limitiert.

Um diese Probleme zu umgehen, weist der Drehratensensor 100 die zumindest eine, vorzugsweise mehrere, Kopplungsstruktur 120 auf. Die Kopplungsstruktur 120 wird über mit dem Substrat verbundene Elektroden 130 mit Kräften beaufschlagt. Dabei ist die Kopplungsstruktur 120 derart ausgebildet, dass eine präzise Übertragung dieser Kompensationskräfte auf die Ringstruktur 110 ermöglicht wird. Die konkrete Ausgestaltung der Kopplungsstruktur 120 und der Elektroden 130 ist hierbei beliebig, solange diese Funktion erreicht werden kann.

Insbesondere muss es die Kopplungsstruktur 120 ermöglichen, die Ringstruktur 110 mit tangentialen Kräften zu beaufschlagen, die in der Fig. 1 durch den Doppelpfeil A symbolisiert sind. Dies wird z.B. dadurch erreicht, dass sich die Kopplungsstruktur 120 um eine Achse senkrecht zum Substrat drehen lässt, wodurch auf Verbindungsstellen zwischen Kopplungsvorrichtung 120 und Ringstruktur 110 eine Zugkraft in tangentialer Richtung wirkt.

Wie in der Fig. 1 dargestellt, ist die Kopplungsstruktur 120 hierfür vorzugsweise an genau einer Stelle der Ringstruktur 110 mit dieser verbunden. Dies erlaubt es, den Ansatzpunkt der Kompensationskraft genau zu bestimmen. Die Kopplungsstruktur 120 kann aber auch an mehreren Stellen mit der Ringstruktur 110 verbunden sein, wodurch z.B. eine Formstabilität in dem Verbindungsbereich erreicht werden kann.

Wie in der Fig. 1 gezeigt ist, können die Elektroden 130 zur Kompensation von Quadraturfehlern an verschiedenen Teilen der Kopplungsstruktur 120 angeordnet sein. Dadurch wird die effektiv für die Elektrodenflächen zur Verfügung stehende Fläche vergrößert. Auch lassen sich Auslegungen der Elektroden 130 erreichen, die von der Plattenstruktur abweichen und genau auf die Funktion der Elektroden 130 abgestimmt sind. Dies gilt nicht nur für die Elektroden 130 zur Kompensation von Quadraturfehlern, sondern für sämtliche an die Kopplungsstruktur 120 angreifende Elektroden, wie sie weiter unten noch im Detail beschrieben werden.

Hierbei können die Elektroden zur Kompensation von Quadraturfehlern vorzugsweise an Teilen der Kopplungsstruktur 120 angeordnet sein, die sich im Wesentlichen in die radiale Richtung der Ringstruktur 110 erstrecken. Als im Wesentlichen radial laufend sind hier Bestandteile zu verstehen, die einen größeren radialen als tangentialen Richtungsvektor aufweisen, wie etwa die in Fig. 1 dargestellten, außen liegenden Seiten der Kopplungsstruktur 120. Dann können die Elektroden 130 z.B. in einfacher Weise als Plattenelektroden gestaltet werden, die auf die im Wesentlichen radial laufenden Teile der Kopplungsstruktur 120 hierauf senkrecht stehende Kräfte erzeugen, d.h. im Wesentlichen tangential laufende Kräfte, die geeignet sind, die Kopplungsstruktur 120 tangential zu verschieben oder zu verdrehen.

Neben tangentialen Kräften können über die Kopplungsstruktur 120 bei Verwendung einer entsprechenden Form und von entsprechenden Elektroden 130 auch radiale Kräfte an die Ringstruktur 110 angelegt werden. Die Kopplungsstruktur 120 erlaubt also im Gegensatz zu den herkömmlicher Weise verwendeten Plattenelektroden 135 Kompensationskräfte in sämtliche Richtungen zu erzeugen und diese auch präzise an die Ringstruktur 110 anzulegen. Dadurch lassen sich effektiv Quadraturfehler reduzieren, insbesondere bei der Verwendung von mehreren Kopplungsstrukturen 120. Auch lässt sich auf diese Weise durch Aufteilung der Elektrodenfläche eine größere Elektrodenfläche erreichen.

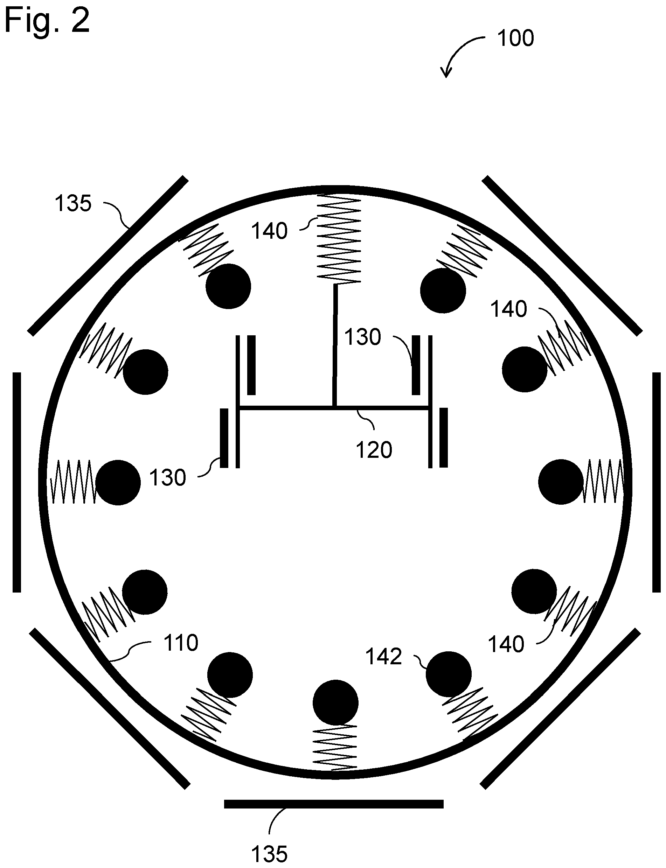

Wie in der Fig. 2 gezeigt kann der Drehratensensor 100 erste Federelemente 140 aufweisen, die die Ringstruktur 110 über Ankerstrukturen 142 mit dem Substrat verbinden. Die ersten Federelemente 140 dienen dazu, die Ringstruktur 110 über dem Substrat zu halten und gleichzeitig die zum Betrieb des Drehratensensors 100 notwendigen Schwingungen zu ermöglichen. Die Ausgestaltung der ersten Federelemente 140 steht hierbei im Belieben des Fachmanns. Dies ist in der Fig. 2 durch die Verwendung einer Zickzacklinie als dem allgemeinen Piktogramm für "Feder" symbolisiert. Ausschlaggebend ist in diesem Zusammenhang nicht die Form der ersten Federelemente 140, sondern dass die zumindest eine Kopplungsstruktur 120 und sämtliche erste Federelemente 140 an der gleichen Seite der Ringstruktur 110 angreifen. Dies ist in der Fig. 2 die Innenseite der Ringstruktur 110. Die ersten Federelemente 140 und die zumindest eine Kopplungsstruktur 120 könnten sich aber auch außerhalb der Ringstruktur 110 befinden.

Durch die Anbindung der ersten Federelemente 140 und der Kopplungsstruktur(en) 120 an der gleichen Seite der Ringstruktur 110 kann ein kompakter Aufbau des Drehratensensors 100 erreicht werden. Insbesondere ist die Seite der Ringstruktur 110 ohne Federelemente 140 und Kopplungsstruktur(en) 120 frei für die Anordnung verschiedener weiterer Komponenten des Drehratensensors 100.

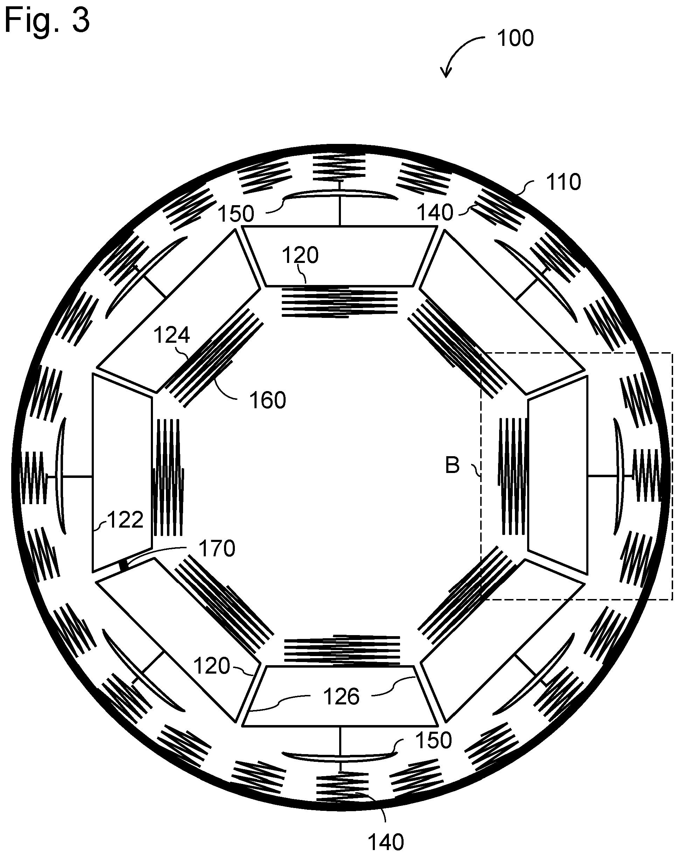

Die Fig. 3 zeigt eine weitere schematische Darstellung einer beispielhaften Ausgestaltung eines Drehratensensors 100. Neben den zuvor beschriebenen Komponenten weist der Drehratensensor 100 eine Mehrzahl der Kopplungsstrukturen 120 auf, die gleichmäßig entlang der Umfangsrichtung der Ringstruktur 110 verteilt sind. Zudem sind im Beispiel der Fig. 3 zweite Federelemente 150, die die Kopplungsstrukturen 120 mit der Ringstruktur 110 verbinden, und dritte Federelemente 160 gezeigt, die die Kopplungsstrukturen 120 mit dem Substrat verbinden. Ankerstrukturen, die die ersten und dritten Federelemente 140, 160 mit dem Substrat verbinden, sind der Übersichtlichkeit halber nicht dargestellt. Die zweiten und dritten Federelemente 150, 160 sind hierbei jeweils für sich fakultativ.

Die Verwendung einer Mehrzahl von Kopplungsstrukturen 120, die entlang des Umfangs der Ringstruktur 110 verteilt sind, erlaubt es, die Ringstruktur 110 an jeder Stelle ausreichend mit Kompensationskräften zu beaufschlagen, um Quadraturfehler zu kompensieren. Die optionale gleichmäßige Verteilung hat den weiteren Vorteil, dass die Resultate der Krafteinwirkung auf die Ringstruktur leichter abgeschätzt bzw. vorhergesagt werden können, da sich eine gleichmäßige Verteilung leichter theoretisch behandeln lässt. Auf diese Weise garantieren zudem gleich ausgebildete Kopplungsstrukturen 120 die gewünschte Rotationssymmetrie des Drehratensensors 100. Da es einfacher ist, gleich ausgebildete Kopplungsstrukturen 120 herzustellen als verschieden geformte (z.B. wegen der einfacheren Herstellbarkeit von gleich dimensionierten Strukturen in einem Ätzprozess), vereinfacht die gleichmäßige Verteilung der Kopplungsstrukturen 120 auch den Herstellungsprozess des Drehratensensors 100.

Wie in der Fig. 3 gezeigt können die Kopplungsstrukturen 120 als Rahmen ausgebildet sein, die an einer ersten Seite 122 mit der Ringstruktur 110 und an einer zweiten gegenüberliegenden Seite 124 mit dem Substrat verbunden sind. Dies erlaubt es, zumindest einen Teil der auf dem Substrat feststehenden Elektroden 130, die mit den Kopplungsstrukturen 120 wechselwirken können, innerhalb der Rahmen auszubilden. Die Strukturen, um Bewegungen der Kopplungsstrukturen 120 anzuregen/zu detektieren, können auf diese Weise in kompakter platzsparender Weise im Drehratensensor 100 angeordnet werden. Die Verwendung von Rahmen vergrößert zudem die Fläche die mit Elektroden wechselwirken kann im Vergleich zur Fläche von Umfangsabschnitten der Ringstruktur 110, die mit einfachen Elektrodenplatten 135 in Wechselwirkung stehen.

Wie in der Fig. 3 weiter beispielhaft dargestellt können die ersten Seiten 122 und die zweiten Seiten 124 der Rahmen länger sein als dritte Seiten 126 der Rahmen, die sich im Wesentlichen in radialer Richtung der Ringstruktur 110 erstrecken. Die Rahmen haben also die Form eines Trapezes, das an den Längsseiten mit der Ringstruktur 110 bzw. dem Substrat verbunden ist. Dies ist zum einen eine platzsparende Ausgestaltung der Kopplungsstrukturen 120.

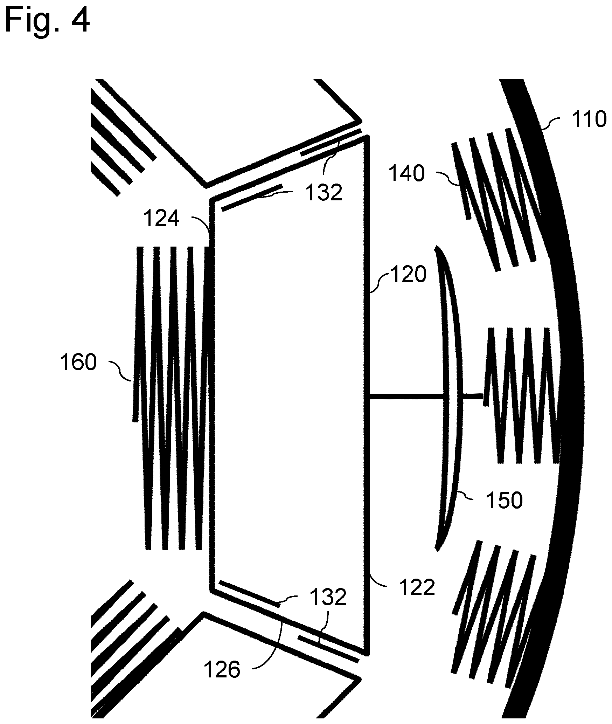

Zum anderen erlaubt diese Form der Kopplungsstrukturen 120, Elektroden 132 zur Kompensation von Quadraturfehlern in elektrische Wechselwirkung mit den dritten Seiten 126 zu setzen. Dies ist beispielhaft in der Fig. 4 dargestellt, die eine Vergrößerung des mit B gekennzeichneten Bereichs der Fig. 3 zeigt. Durch diese Struktur kann die Kompensation der Quadraturfehler effektiv herbeigeführt werden, da durch die vergleichsweise langen ersten Seiten 122 und zweiten Seiten 124 ein großer Hebelarm zwischen dem Ansatzpunkt der durch die Elektroden 132 hervorgerufenen Kraft und der Verbindung zwischen Kopplungsvorrichtung 120 und Ringstruktur 110 vorhanden ist. Ein vergleichsweise kleiner Kraftübertrag an den dritten Seiten 126 führt also zu einer durch den Hebelarm vergrößerten Kraft auf die Ringstruktur 110, der zur Kompensation von Quadraturfehlern verwendet werden kann. Das Verhältnis der Längen von erster Seite 122 zu den dritten Seiten 126 kann dabei zwischen 3:1 und 10:1 betragen, z.B. 5:1.

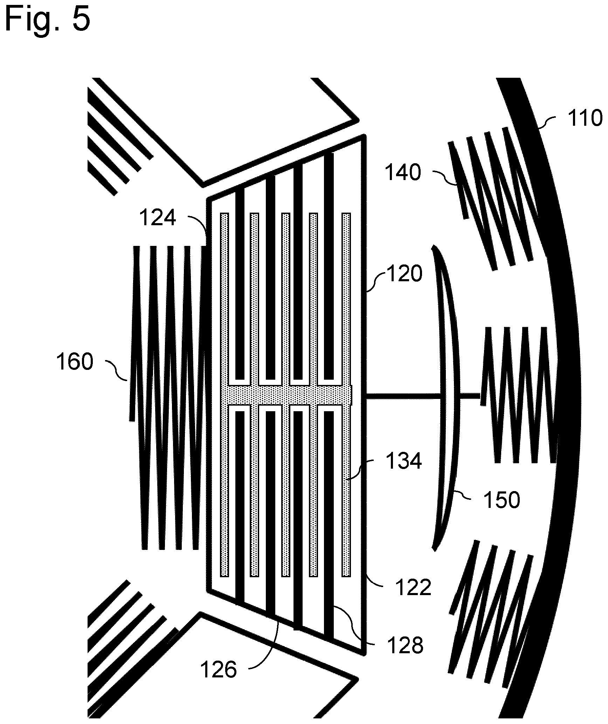

Neben oder anstatt der Elektroden 132 zur Kompensation von Quadraturfehlern können in oder an den die Kopplungsstrukturen 120 darstellenden Rahmen auch auf dem Substrat feststehende Elektroden 134 ausgebildet sein, über die die Anregungsschwingung der Ringstruktur 110 erzeugt werden, bzw. über die die Detektionsschwingung gemessen wird. Beispiele für derartige Elektrodenaufbauten sind in den Fig. 5 bis 7 mit Bezug auf den Bereich B der Fig. 3 gezeigt. In all diesen Figuren wird deutlich, dass sich sowohl die Elektrodenfläche als auch die Ausgestaltungsmöglichkeiten für die einzelnen Elektroden im Vergleich zur Verwendung von außenliegenden Plattenelektroden stark verbessert haben.

Die Fig. 5 zeigt als Platten aufgebaute Elektroden 134 zum Antreiben/Auslesen der Schwingungen der Ringstruktur 110, die sich mit Elektrodenplatten 128 abwechseln, die mit dem Rahmen verbunden sind. Die Elektroden 134 und die Elektroden 128 bilden Plattenkondensatoren, über die der Rahmen mit einer Kraft in radialer Richtung beaufschlagt werden kann, bzw. mit denen eine solche Kraft detektiert werden kann. Die in der Fig. 5 gezeigte Struktur kann in einer Mehrzahl der Kopplungsvorrichtungen 120 verwendet werden. Sie kann in einzelne Kopplungsvorrichtungen 120 allein für den Antrieb und in anderen allein für die Detektion verwendet werden. Die gleiche Struktur kann aber auch im zeitlichen Multiplex für beide Aufgaben verwendet werden.

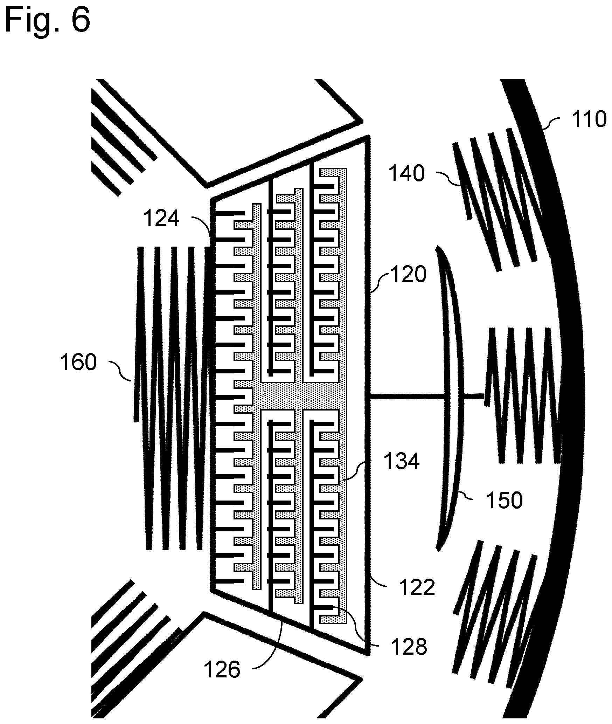

In der Fig. 6 sind die Elektroden 134 zum Antreiben/Auslesen der Schwingungen der Ringstruktur als Kammelektroden ausgebildet, die in Kammelektroden 128 eingreifen, die mit dem Rahmen verbunden sind. Auch mit einem derartigen Aufbau lassen sich radiale Bewegungen anregen/detektieren.

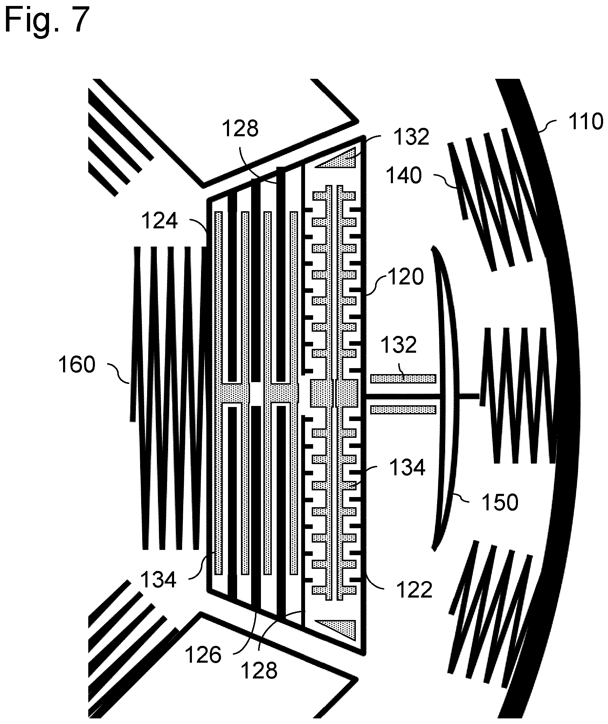

Die Fig. 7 zeigt eine Kombination der verschiedenen in den Fig. 4 bis 6 gezeigten Elektrodenformen. Neben als Platten und Kämmen ausgebildeten Elektroden 134 zum Antreiben/Auslesen und deren mit dem Rahmen verbundenen Gegenelektroden 128 sind auch Elektroden 132 zur Kompensation von Quadraturfehlern vorhanden, die mit dem Rahmen sowie mit der Verbindung des Rahmens zur Ringstruktur 110 wechselwirken können.

Die Fig. 4 bis 7 zeigen, dass durch die Rahmenstruktur eine erhebliche Platzersparnis zusätzlich zur vollen Funktionalität erreicht werden kann. In der Zusammenschau mit der Fig. 3 und der darin gezeigten Anordnung der ersten Federelemente 140 ergibt sich ein äußerst kompakter Aufbau des Drehratensensors 100.

Wie oben diskutiert können über die Kopplungsstrukturen 120 insbesondere radiale Kräfte an die Ringstruktur 110 angelegt werden. Die Amplitude der Verformung der Ringstruktur 110, die durch diese Kräfte hervorgerufen wird, lässt sich durch entsprechend ausgestaltete zweite Federelemente 150 verstärken. Hierfür müssen die zweiten Federelemente 150 bezüglich radialer Auslenkungen eine geringe Federkonstante aufweisen Eine in radiale Richtung weiche Feder führt bei einem Kraftstoß mit kleiner Amplitude zu einer großen Verformung der Feder, die sich dann auf die Ringstruktur 110 überträgt. Auf diese Weise kann durch eine geeignete Wahl der Verbindung zwischen Kopplungsstruktur 120 und Ringstruktur 110 eine Amplitudenverstärkung erreicht werden, die für die Beaufschlagung der Ringstruktur 110 mit Antriebs- oder Kompensationskräften von Vorteil sein kann.

Wie in der Fig. 3 gezeigt können die zweiten Federelemente 150 z.B. als doppelt gefaltete Federn ausgebildet sein. Diese können zudem mit den ersten Federelementen 140 zusammenwirken. Die zweiten Federelemente 150 können aber auch direkt mit der Ringstruktur 110 verbunden sein. Anstatt der gezeigten doppelt gefalteten Federn lässt sich auch jede andere Federgestaltung verwenden, die in radialer Richtung ausreichend weich ist, um den genannten Zweck der Amplitudenverstärkung zu erzielen.

Die ebenfalls in Fig. 3 gezeigten, dritten Federelemente 160 dienen dazu, die Beweglichkeit der Kopplungsstrukturen 120 zu erhöhen. Damit wird die Kräfteübertragung von den Kopplungsstrukturen 120 auf die Ringstruktur 110 vereinfacht. Die dritten Federelemente 160 können hierbei je nach technischer Anforderung ausgebildet sein.

Wie in der Fig. 3 durch die Linie 170 angedeutet können zumindest zwei der Kopplungsstrukturen 120 derart miteinander gekoppelt sind, dass ihre Bewegungen miteinander gekoppelt sind. Die Bewegung der einen Kopplungsstruktur 120 beeinflusst dann also die Bewegung der anderen Kopplungsstruktur 120 und umgekehrt. Insbesondere kann es von Vorteil sein, dass sich benachbarte Kopplungsstrukturen 120 im Gleichtakt oder im Gegentakt bewegen, um eine gewünschte Schwingungsmode der Ringstruktur 110 hervorzurufen und/oder zu stabilisieren. Die Kopplung der Kopplungsstrukturen 120 untereinander kann dabei jede Form annehmen, die dieses Ziel erreichen lässt.

Wie aus der obenstehenden Beschreibung klar wird, zeichnet sich der Drehratensensor 100 durch die Kopplungsstruktur 120 aus, die derart ausgebildet ist, dass sie geeignet ist, zusammen mit auf dem Substrat feststehenden Elektroden 130 einen Quadraturfehler des Drehratensensors 100 zu kompensieren. Auf diese Weise können besonders verlässliche ringförmige Drehratensensoren 100 bereitgestellt werden.

## Patentansprüche

1. Mikroelektromechanischer Drehratensensor (100) mit Ankerstrukturen (142), über die der Drehratensensor (100) mit einem externen Substrat verbunden ist;
auf dem Substrat feststehenden Elektroden (130, 132);
einer flexiblen Ringstruktur (110), die in Ruhe einen Kreis formt und geeignet ist, im Wesentlichen parallel zu der Ebene des Kreises über dem Substrat eine Anregungsschwingung auszuführen, der bei einer Drehung der Ringstruktur (110) eine durch die Corioliskraft erzeugte Detektionsschwingung überlagert wird;
zumindest einer Kopplungsstruktur (120), die mit der Ringstruktur (110) verbunden und derart ausgebildet ist, dass sie geeignet ist, zusammen mit den auf dem Substrat feststehenden Elektroden (130, 132) einen Quadraturfehler des Drehratensensors (100) zu kompensieren; und
ersten Federelementen (140) mit jeweils zwei Enden, die an ihrem ersten Ende an die Ringstruktur (110) angreifen und an ihrem zweiten Ende über die Ankerstrukturen (142) mit dem Substrat verbunden sind; wobei
sich in jedem ersten Federelement (140) das erste Ende und das zweite Ende in Bezug auf einen Mittelpunkt des jeweiligen ersten Federelementes (140) in einer Hauptausdehnungsrichtung des jeweiligen ersten Federelements (140) gegenüberliegen
die zumindest eine Kopplungsstruktur (120) und die ersten Federelemente (140) an der gleichen Seite der Ringstruktur (110) angreifen.

2. Drehratensensor (100) nach Anspruch 1, wobei
der Drehratensensor (100) mehr als eine Kopplungsstruktur (120) aufweist, wobei die Kopplungsstrukturen (120) gleichmäßig entlang der Umfangsrichtung der Ringstruktur (110) verteilt sind.

3. Drehratensensor (100) nach einem der vorherigen Ansprüche, wobei
die Elektroden (132) zur Kompensation von Quadraturfehlern in elektrischer Wechselwirkung mit Teilen der zumindest einen Kopplungsstruktur (120) steht, die sich im Wesentlichen in radialer Richtung der Ringstruktur (110) erstreckt.

4. Drehratensensor (100) nach einem der vorherigen Ansprüche, wobei
die zumindest eine Kopplungsstruktur (120) jeweils als ein Rahmen ausgebildet ist, der an einer ersten Seite (122) mit der Ringstruktur (110) und an einer zweiten gegenüberliegenden Seite (124) mit dem Substrat verbunden ist; und
zumindest ein Teil der auf dem Substrat feststehenden Elektroden (130, 132) innerhalb des Rahmens beziehungsweise der Rahmen ausgebildet ist.

5. Drehratensensor (100) nach Anspruch 4, wobei jeder Rahmen die Form eines Trapezes hat; und wobei
die Elektroden (132) zur Kompensation von Quadraturfehlern in elektrischer Wechselwirkung mit einer dritten Seite des Rahmens beziehungsweise mit dritten Seiten (126) der Rahmen stehen, die sich im Wesentlichen in radialer Richtung der Ringstruktur (110) erstreckt beziehungsweise erstrecken.

6. Drehratensensor (100) nach Anspruch 5, wobei
die ersten und zweiten Seiten (122, 124) des Rahmens beziehungsweise der Rahmen länger sind als die dritte Seite des Rahmens beziehungsweise als die dritten Seiten (126) der Rahmen.

7. Drehratensensor (100) nach einem der vorherigen Ansprüche, wobei
die zumindest eine Kopplungsstruktur (120) derart ausgebildet ist, dass sie geeignet ist, zusammen mit auf dem Substrat feststehenden Elektroden (134) die Anregungsschwingung zu erzeugen und/oder die Detektionsschwingung zu messen.

8. Drehratensensor (100) nach einem der vorherigen Ansprüche, des Weiteren mit
zweiten Federelementen (150), die die zumindest eine Kopplungsstruktur (120) mit der Ringstruktur (110) verbinden; wobei
die zweiten Federelemente (150) in radialer Richtung der Ringstruktur (110) derart verformbar sind, dass eine radiale Auslenkung der zumindest einen Kopplungsstruktur (120) zu einer radialen Auslenkung der Ringstruktur (110) führt, die größer ist als die radiale Auslenkung der zumindest einen Kopplungsstruktur (120).

9. Drehratensensor (100) nach einem der vorherigen Ansprüche, des Weiteren mit
dritten Federelementen (160), die die zumindest eine Kopplungsstruktur (120) mit dem Substrat verbinden.

10. Drehratensensor (100) nach einem der vorherigen Ansprüche, wobei
der Drehratensensor (100) mehr als eine Kopplungsstruktur (120) aufweist, und zumindest zwei Kopplungsstrukturen durch ein zusätzliches Verbindungselement (170) derart miteinander gekoppelt sind, dass ihre Bewegungen miteinander gekoppelt sind.

## Claims

1. A microelectromechanical angular rate sensor (100), comprising:
Anchor structures (142) through which the angular rate sensor (100) is connected to an external substrate;
electrodes (130, 132) fixed to the substrate;
a flexible ring structure (110) which forms a circle at rest and which is suitable for producing an excitation oscillation substantially parallel to the plane of the circle above the substrate, said excitation oscillation being superimposed with a detection oscillation generated by the Coriolis force during a rotation of the ring structure (110);
at least one coupling structure (120) which is connected to the ring structure (110) and is designed in such a way that it is, together with the electrodes (130, 132) which are fixed to the substrate, suitable for compensating for a quadrature error of the angular rate sensor (100); and
first spring elements (140), each having two ends, which connect the ring structure (110) at their first end and are connected to the substrate at their second end via the anchor structures (142); wherein
in each first spring element (140), the first end and the second end are opposite each other with respect to a center point of the respective first spring element (140) in a principal direction of extension of the respective first spring element (140);
the at least one coupling structure (120) and the first spring elements (140) act on the same side of the ring structure (110).

2. The angular rate sensor (100) according to claim 1, wherein
the angular rate sensor (100) has more than one coupling structure (120), wherein the coupling structures (120) are evenly distributed along the circumferential direction of the ring structure (110).

3. The angular rate sensor (100) according to any one of the preceding claims, wherein
the electrodes (132) for compensating for quadrature errors are in electrical interaction with portions of the coupling structures (120) that extend substantially in a radial direction of the ring structure (110).

4. The angular rate sensor (100) according to any one of the preceding claims, wherein
the at least one coupling structure (120) is designed in each case as a frame that is connected to the ring structure (110) on a first side (122) and to the substrate on a second opposite side (124); and
at least one portion of the electrodes (130, 132) which are fixed to the substrate is formed within the frame or the frames, respectively.

5. The angular rate sensor (100) according to claim 4, wherein each frame is shaped like a trapezoid; and wherein
the electrodes (132) for compensating for quadrature errors are in electrical interaction with a third side of the frame or third sides (126) of the frames, respectively, which extend(s) substantially in a radial direction of the ring structure (110).

6. The angular rate sensor (100) according to claim 5, wherein
the first and second sides (122, 124) of the frame or the frames, respectively, are longer than the third side of the frame or the third sides (126) of the frames, respectively.

7. The angular rate sensor (100) according to any one of the preceding claims, wherein
the coupling structures (120) are designed in such a way that they, together with electrodes (134) which are fixed to the substrate, are suitable for generating the excitation oscillation and/or measuring the detection oscillation.

8. The angular rate sensor (100) according to any one of the preceding claims, further comprising:
second spring elements (150) which connect the coupling structures (120) to the ring structure (110); wherein
the second spring elements (150) are deformable in a radial direction of the ring structure (110) in such a way that a radial deflection of the at least one coupling structure (120) leads to a radial deflection of the ring structure (110) that is greater than the radial reflection of the at least one coupling structure (120).

9. The angular rate sensor (100) according to any one of the preceding claims, further comprising:
third spring elements (160) which connect the at least one coupling structure (120) to the substrate.

10. The angular rate sensor (100) according to any one of the preceding claims, wherein
the angular rate sensor (100) has more than one coupling structure (120), and at least two coupling structures are coupled to each other through a connection (170) in such a way that their movements are coupled to each other.

## Revendications

1. Capteur de vitesse de rotation microélectromécanique (100) comprenant
des structures d'induit (142) par l'intermédiaire desquelles le capteur de vitesse de rotation (100) est relié à un substrat externe ;
des électrodes (130, 132) fixes sur le substrat ;
une structure annulaire flexible (110) qui forme un cercle au repos et est adaptée pour exécuter au-dessus du substrat, de manière sensiblement parallèle au plan du cercle, une oscillation d'excitation qui, lors d'une rotation de la structure annulaire (110), est superposée à une oscillation de détection générée par la force de Coriolis ;
au moins une structure de couplage (120) qui est reliée à la structure annulaire (110) et est réalisée de manière telle qu'elle soit adaptée pour compenser, conjointement aux électrodes (130, 132) fixes sur le substrat, une erreur de quadrature du capteur de vitesse de rotation (100) ; et
de premiers éléments de ressort (140), comprenant chacun deux extrémités, qui s'engagent par leur première extrémité sur la structure annulaire (110) et sont reliés au substrat par leur seconde extrémité par l'intermédiaire des structures d'induit (142) ; dans lequel
dans chaque premier élément de ressort (140), la première extrémité et la seconde extrémité sont opposées par rapport à un point central du premier élément de ressort (140) en question dans une direction d'extension principale du premier élément de ressort (140) en question
l'au moins une structure de couplage (120) et les premiers éléments de ressort (140) s'engagent du même côté de la structure annulaire (110).

2. Capteur de vitesse de rotation (100) selon la revendication 1, dans lequel
le capteur de vitesse de rotation (100) présente plus d'une structure de couplage (120), dans lequel les structures de couplage (120) sont réparties uniformément le long de la direction périphérique de la structure annulaire (110).

3. Capteur de vitesse de rotation (100) selon l'une des revendications précédentes, dans lequel
pour compenser des erreurs de quadrature, les électrodes (132) sont en interaction électrique avec des parties de l'au moins une structure de couplage (120) qui s'étend sensiblement dans la direction radiale de la structure annulaire (110).

4. Capteur de vitesse de rotation (100) selon l'une des revendications précédentes, dans lequel
l'au moins une structure de couplage (120) est réalisée respectivement comme un cadre qui est relié à la structure annulaire (110) d'un premier côté (122) et au substrat d'un deuxième côté (124) opposé ; et
au moins une partie des électrodes (130, 132) fixes sur le substrat est réalisée à l'intérieur du cadre ou des cadres.

5. Capteur de vitesse de rotation (100) selon la revendication 4, dans lequel chaque cadre a la forme d'un trapèze ; et dans lequel
pour compenser des erreurs de quadrature, les électrodes (132) sont en interaction électrique avec un troisième côté du cadre ou avec de troisièmes côtés (126) des cadres qui s'étend ou s'étendent sensiblement dans la direction radiale de la structure annulaire (110).

6. Capteur de vitesse de rotation (100) selon la revendication 5, dans lequel
les premier et deuxième côtés (122, 124) du cadre ou des longerons de cadre sont comme le troisième côté du cadre, respectivement les troisièmes côtés (126) des cadres.

7. Capteur de vitesse de rotation (100) selon l'une des revendications précédentes, dans lequel
l'au moins une structure de couplage (120) est réalisée de manière telle qu'elle soit adaptée pour générer l'oscillation d'excitation et/ou mesurer l'oscillation de détection conjointement aux électrodes (134) fixes sur le substrat.

8. Capteur de vitesse de rotation (100) selon l'une des revendications précédentes, comprenant par ailleurs
de deuxièmes éléments de ressort (150) qui relient l'au moins une structure de couplage (120) à la structure annulaire (110) ; dans lequel
les deuxièmes éléments de ressort (150) sont déformables dans la direction radiale de la structure annulaire (110) de manière telle qu'une déviation radiale de l'au moins une structure de couplage (120) entraîne une déviation radiale de la structure annulaire (110) qui soit supérieure à la déviation radiale de l'au moins une structure de couplage (120).

9. Capteur de vitesse de rotation (100) selon l'une des revendications précédentes, comprenant par ailleurs
de troisièmes éléments de ressort (160) qui relient l'au moins une structure de couplage (120) au substrat.

10. Capteur de vitesse de rotation (100) selon l'une des revendications précédentes, dans lequel
le capteur de vitesse de rotation (100) présente plus d'une structure de couplage (120), et au moins deux structures de couplage sont couplées entre elles par un élément de liaison (170) supplémentaire de manière telle que leurs mouvements soient couplés entre eux.
